# EUROPÄISCHE PATENTANMELDUNG

(11) **EP 2 256 796 A1**
(43) Veröffentlichungstag der Anmeldung: **01.12.2010**
(21) Anmeldenummer: 09007204.2
(22) Anmeldetag: 29.05.2009
(51) Int. Cl.: H01L 21/677, B65G 21/20, B65G 49/06

(54) **Vorrichtung zum Transport von Wafern und/oder Solarzellen**

(71) Anmelder: Hennecke Systems GmbH, 53909 Zülpich (DE)
(72) Erfinder: Hennecke, Heinrich Peter, 53909 Zülpich (DE); Odenthal, Heinz F., 53909 Zülpich (DE)
(74) Vertreter: Rohmann, Michael

(57) **Zusammenfassung**

Vorrichtung zum Transport von Wafern und/oder Solarzeiten, wobei zumindest ein Endlostransportband für den Transport der Wafer von einem Übernahmebereich zu einem Ablagebereich des Endlostransportbandes vorhanden ist. Das Endlostransportband weist eine Vielzahl von Saugöffnungen auf und es ist zumindest eine Ansaugvorrichtung vorgesehen, mit der ein Unterdruck an dem Endlostransporiband bzw. an den Saugöffnungen anlegbar ist. In dem Übernahmebereich des Endlostransportbandes ist zumindest ein Saugelement angeordnet, mit welchem Saugelement ein auf einer unterhalb des Endlostransportbandes angeordneten Unterlage aufliegender Wafer ansaugbar und von der Unterlage abhebbar ist. Der von dem Saugelement angesaugte Wafer wird anschließend aufgrund des an den Saugöffnungen des Endlostransportbandes anliegenden Unterdruckes an der Unterseite des Endlostransportbandes angesaugt und abtransportiert.

## Beschreibung

Die Erfindung betrifft eine Vorrichtung zum Transport von Wafem und/oder Solarzelle. Unter Wafem versteht man sehr dünne Scheiben, insbesondere Siliciumscheiben, die insbesondere die Basis für die Herstellung von Solarzellen bilden. Die Dicke der Wafer liegt in der Regel deutlich unter 1 mm, insbesondere unter 0,2 mm. - Nachfolgend wird statt des Begriffes "Wafer und/oder Solarzellen" vereinfacht lediglich der Begriff "Wafer" verwendet. - Bei den vorstehend beschriebenen Wafem handelt es sich um sehr empfindliche Gegenstände. Die Handhabung und der Transport solcher Wafer muss stets sehr schonend erfolgen, da ansonsten leicht mechanische Beschädigungen der Wafer resultieren.

Die aus der Praxis bekannten Vorrichtungen zum Transport von Wafem sind für eine schonende Handhabung der Wafer oftmals sehr aufwendig und komplex ausgebildet. Bei weniger aufwendig und vereinfacht ausgebildeten Vorrichtungen resultiert aus der Vereinfachung häufig eine höhere Wahrscheinlichkeit der Beschädigung der Wafer, so dass dar Ausschuss an Wafem relativ hoch ist.

Demgegenüber liegt der Erfindung das technische Problem zugrunde eine Vorrichtung der eingangs genannten Art anzugeben, die einerseits einfach und wenig aufwendig aufgebaut ist und andererseits nichtsdestoweniger eine sehr schonende Handhabung bzw. einen sehr schonenden Transport der Wafer zulässt.

Zur Lösung dieses technischen Problems lehrt die Erfindung eine Vorrichtung zum Transport von Wafem und/oder Solarzellen, wobei zumindest ein Endlostransportband für den Transport der Wafer von einem Übernahmebereich des Endlostransportbandes zu einem Ablagebereich des Endlostransportbandes vorhanden ist, wobei das Endlostransportband eine Vielzahl von Saugöffnungen aufweist und wobei zumindest eine Ansaugvorrichtung vorhanden ist, mit der durch Ansaugen von Luft ein Unterdruck an dem Endlostransportband bzw. an den Saugöffnungen des Endlostransportbandes anlegbar ist,
wobei in dem Übernahmebereich des Endlostransportbandes zumindest ein Saugelement angeordnet ist, mit welchem Saugelement ein auf einer unterhalb des Endlostransportbandes angeordneten Unterlage aufliegender Wafer ansaugbar und von der Unterlage abhebbar ist und
wobei der von dem Saugelement angesaugte Wafer anschließend aufgrund des an den Saugöffnungen des Endlostransportbandes anliegenden Unterdruckes an der Unterseite des Endlostransportbandes ansaugbar und mit dem Endlostransportband abtransportierbar ist.

Zweckmäßigerweise wird ein statischer Unterdruck an dem Endlostransportband angelegt. Aufgrund des Ansaugens von Luft durch die zumindest eine Ansaugvorrichtung aus dem Inneren des Endlostransportbandes wird Luft von außen durch die Saugöffnungen des Endlostransportbandes gesaugt und dadurch erfolgt ein Ansaugen bzw. eine Fixierung der Wafer an der nach unten orientierten Oberfläche des Endlostransportbandes. Es liegt im Rahmen der Erfindung, dass die angesaugten Wafer flächig an der nach unten orientierten Oberfläche des Endlostransportbandes anliegen und auf diese Weise von dem Endlostransportband weiter transportiert werden.

Nach einer sehr bevorzugten Ausführungsform der Erfindung ist die Unterlage ein Wafermagazin, in dem ein Waferstapel aus einer Mehrzahl bzw. Vielzahl von übereinander gestapelten Wafem angeordnet ist. Zweckmäßigerweise wird mit dem zumindest einen Saugelement der im Waferstapel oberste Wafer jeweils angesaugt und vom Waferstapel abgehoben. Dieser abgehobene Wafer kommt dann aufgrund der bereits beschriebenen Unterdruckbeaufschlagung an den Saugöffnungen des Endlostransportbandes an der Unterseite des Endlostransportbandes zur Anlage. Empfohlenermaßen erfolgt im Wafermagazin ein Nachführen bzw. Anheben des Waferstapels damit der Abstand zwischen dem im Waferstapel obersten Wafer und der Unterseite des Endlostransportbandes konstant bleibt bzw. im Wesentlichen konstant bleibt. Zweckmäßigerweise sind zumindest im Zwischenraum zwischen der Unterseite des Endlostransportbandes und dem Waferstapel zumindest zwei jeweils an den Seiten des Endlostransportbandes angeordnete Führungen für die zu übernehmenden Wafer vorgesehen. Bei den Führungen kann es sich um vertikal orientierte Führungsplatten und/oder vertikal orientierte Führungsstangen handeln. Die seitlich gegenüberliegenden Führungen verhindern unerwünschte seitliche Verschiebungen der Wafer und begünstigen eine Zentrierung der Wafer an dem Endlostransportband. Bevorzugt ist fernerhin zumindest im Zwischenraum zwischen der Unterseite des Endlostransportbandes und dem Waferstapel zumindest eine an der Rückseite des Waferstapels angeordnete Führung vorgesehen. Auch bei dieser Führung kann es sich um zumindest eine vertikal orientierte Führungsplatte und/oder um zumindest eine vertikal orientierte Führungsstange handeln. Wenn seitliche und rückseitige Führungen verwirklicht sind, können die Wafer von dem Waferstapel lediglich in Transportrichtung des Endlostransportbandes überführt werden und ein unerwünschtes seitliches oder rückseitiges Verschieben der Wafer wird verhindert.

Gemäß einer anderen bevorzugten Ausführungsform ist die Unterlage ein Zuführförderer, mit der die einzelnen Wafer in Förderrichtung hintereinander angeordnet zu dem Endlostransportband bzw. an dem Endlostransportband vorbei förderbar sind. Bei dem Zuführförderer handelt es sich zweckmäßigerweise um ein Förderband, auf dem die Wafer aufliegen. Der Zuführförderer bzw. das Förderband ist bevorzugt quer zum Endlostransportband angeordnet. Zweckmäßigerweise werden die Wafer auf dem Zuführförderer bzw. auf dem Förderband einzeln hintereinander angeordnet transportiert. Grundsätzlich können aber auch mehrere Wafer auf dem Zuführförderer bzw. auf dem Förderband übereinander gestapelt sein. Es liegt im Rahmen der Erfindung, dass die Wafer mit Hilfe des zumindest einen Saugelementes von dem Zuführförderer abgehoben werden und dann - wie beschrieben - zur Anlage an der Unterseite des Endlostransportbandes kommen. Dass die Wafer gemäß der genannten Alternative an dem Endlostransportband vorbei förderbar sind, meint im Rahmen der Erfindung insbesondere, dass nicht alle Wafer von dem Endlostransportband aufgenommen werden müssen sondern vielmehr eine gezielte Auswahl getroffen werden kann.

Eine empfohlene Ausführungsform der Erfindung ist dadurch gekennzeichnet, dass zumindest eine Blasdüseinrichtung vorgesehen ist, mit der der zu übernehmende Wafer - insbesondere der im Wafermagazin aufgenommene Waferstapel - seitlich mit Blasluft beaufschlagbar ist, so dass der zu übernehmende Wafer von der Unterlage abhebbar ist, insbesondere so dass der im Waferstapel jeweils oberste Wafer von dem Waferstapel abhebbar ist. Zweckmäßigerweise ist an jeder Seite des zu übernehmenden Wafers bzw. an jeder Seite des Waferstapels zumindest eine Blasdüse angeordnet. Vorzugsweise erfolgt ein seitliches Eindüsen von Blasluft quer bzw. senkrecht zur Transportrichtung der Wafer. Das Eindüsen der Blasluft dient bei einem Waferstapel zum Auffächern bzw. zur Vereinzelung der Wafer, so dass diese dann jeweils funktionssicher von dem zumindest einen Saugelement angesaugt werden können. Es liegt im Rahmen der Erfindung, dass die Blasluft impulsweise eingedüst wird, so dass eine intervallweise Abgabe der einzelnen Wafer an das Endlostransportband erfolgt. - Gemäß einer Ausführungsform der Erfindung ist an dem Wafermagazin bzw. ist hinter dem Waferstapel des Wafermagazins zumindest ein Vorschubelement vorgesehen, das einen zu übernehmenden Wafer in Transportrichtung schiebt. Bei dem Vorschubelement handelt es sich insbesondere um einen Vorschubkeil oder um eine angetriebene Rolle. Besondere Bedeutung kommt im Rahmen der Erfindung dem zumindest einen im Übernahmebereich des Endlostransportbandes angeordneten Saugelement zu. Vorzugsweise werden für die erfindungsgemäße Vorrichtung zumindest zwei Saugelemente eingesetzt. Saugelement meint insbesondere ein von den Saugöffnungen des Endlostransportbandes unterschiedliches saugendes Element. Es liegt im Rahmen der Erfindung, dass es sich um ein ein- und abschaltbares Saugelement handelt. Zweckmäßigerweise wird das Saugelement zugeschaltet, wenn ein Wafer von dem Endlostransportband übernommen werden soll. Empfohlenermaßen handelt es sich bei dem Saugelement um ein Unterdruck erzeugendes düsenartiges Saugelement. Gemäß einer besonders bevorzugten Ausführungsform der Erfindung ist das zumindest eine Saugelement im Übernahmebereich des Endlostransportbandes ein Bemoulli-Saugelement. Es liegt im Rahmen der Erfindung, dass bei einem solchen Bemoulli-Saugelement über eine Druckluftzuführung zugeführte Druckluft radial nach außen strömt und mittig ein Unterdruck erzeugt wird, durch den ein zu übernehmender Wafer nach oben gesaugt wird. Zweckmäßigerweise werden zumindest zwei Bernouili-Saugelemente eingesetzt. Nach einer anderen Ausführungsform der Erfindung ist das zumindest eine Saugelement im Übernahmebereich des Endlostransportbandes eine Injektordüse. Es empfiehlt sich, dass das zumindest eine Saugelement lediglich im Übernahmebereich und nicht im weiter unten noch erwähnten Transportbereich des Endlostransportbandes angeordnet ist.

Gemäß einer Ausführungsvariante der Erfindung wird das Endlostransportband von lediglich einem einzigen endlosen Transportband gebildet. Es liegt im Rahmen der Erfindung, dass die von diesem Transportband aufgenommenen bzw. transportierten Wafer an beiden Seiten über das Transportband vorstehen. Zweckmäßigerweise ist im Übernahmebereich einer solchen Vorrichtung zumindest ein Saugelement an jeder Seite des Transportbandes vorgesehen. Nach einer weiteren Ausführungsvariante der Erfindung wird das Endlostransportband von zwei parallel zueinander und vorzugsweise mit Abstand voneinander angeordneten endlosen Transportbändern gebildet, die für den Transport der Wafer vorgesehen sind und die jeweils eine Vielzahl von Saugöffnungen aufweisen. Zweckmäßigerweise fluchten zumindest die unterseitigen Oberflächen dieser beiden Transportbänder miteinander. Empfohlenermaßen liegt ein transportierter Wafer an den unterseitigen Oberflächen beider Transportbänder an. Es liegt dabei im Rahmen der Erfindung, dass ein transportierter Wafer an den beiden Außenseiten der beiden Transportbänder über die Transportbänder vorsteht. Es liegt weiterhin im Rahmen der Erfindung, dass zumindest eine Ansaugvorrichtung vorgesehen ist, mit der durch Ansaugen von Luft ein Unterdruck an beiden endlosen Transportbändern bzw. an deren Saugöffnungen anlegbar ist. Nach bevorzugter Ausführungsform der Erfindung ist das im Übernahmebereich vorgesehene zumindest eine Saugelement zwischen den beiden das Endlostransportband bildenden endlosen Transportbändern angeordnet. Gemäß einer Ausführungsvariante sind dabei zwei Saugelemente in Transportrichtung der Wafer hintereinander angeordnet. Gemäß einer anderen Ausführungsform sind drei Saugelemente, insbesondere Bernoulii-Saugelemente dreieckförmig zwischen den beiden Transportbändern angeordnet.

Zweckmäßigerweise werden die Wafer an der Unterseite des Endlostransportbandes einzeln mit Abstand zueinander und in Transportrichtung hintereinander transportiert. - Es liegt im Rahmen der Erfindung, dass das Endlostransportband zumindest zwei, vorzugsweise zumindest drei in Transportrichtung der Wafer hintereinander angeordnete Ansaugkammern aufweist, wobei bei zumindest zwei, vorzugsweise bei zumindest drei Ansaugkammern die Luftansaugung bzw. die Unterdruckerzeugung jeweils separat einstellbar ist und wobei eine Ansaugkammer bzw. zumindest eine Ansaugkammer dem Ablagebereich für die Wafer zugeordnet ist. Gemäß einer Ausführungsform der Erfindung weist das Endlostransportband drei Ansaugkammern auf. Zweckmäßigerweise ist zumindest eine Ansaugkammer dem Übernahmebereich des Endlostransportbandes zugeordnet und ist zumindest eine Ansaugkammer dem Transportbereich des Endlostransportbandes zugeordnet. Transportbereich des Endlostransportbandes meint den Bereich zwischen dem Übernahmebereich und dem Ablagebereich des Endlostransportbandes. Es liegt weiterhin im Rahmen der Erfindung, dass zumindest eine Ansaugkammer dem Ablagebereich des Endlostransportbandes zugeordnet ist. Nach einer Ausführungsvariante kann bei dieser Ansaugkammer zur Ablage eines Wafers die Luftansaugung durch die Ansaugvorrichtung im Vergleich zu der Luftansaugung einer Ansaugkammer des Transportbereiches und/oder im Vergleich zur Luftansaugung einer Ansaugkammer des Übernahmebereiches reduziert bzw. gedrosselt sein. Grundsätzlich kann die Luftansaugung in einer Ansaugkammer des Ablagebereiches für eine Ablage eines Wafers auch kurzzeitig unterbrochen bzw. gestoppt werden. - Gemäß einer Ausführungsform der Erfindung sind im Ablagebereich des Endlostransportbandes mehrere in Transportrichtung der Wafer hintereinander angeordnete Ablageplätze vorgesehen, wobei die Ablageplätze zweckmäßigerweise unterhalb des Endlostransportbandes angeordnet sind. Bei mehreren Ablageplätzen können dem Ablagebereich mehrere Ansaugkammern zugeordnet sein. Nach einer Ausführungsform kann jedem Ablageplatz für die Wafer eine separate Ansaugkammer zugeordnet sein. Bei den Ablageplätzen handelt es sich im Übrigen insbesondere um Wafermagazine und/oder Fördereinrichtungen bzw. Förderbänder.

Es empfiehlt sich, dass das zumindest eine Endlostransportband über zumindest einen das Endlostransportband abstützenden Bandkörper geführt wird und dass in der Unterseite des Bandkörpers Öffnungen für die Unterdruckbeaufschlagung der in dem Endlostransportband vorhandenen Saugöffnungen vorgesehen sind. Es liegt im Rahmen der Erfindung, dass es sich bei dem Bandkörper um ein Gehäuse und insbesondere um ein metallisches Gehäuse handelt, das beispielsweise aus Aluminium bestehen kann. Zweckmäßigerweise wird das Endlastransportband über zumindest zwei Antriebs- bzw. Umlenkrollen geführt und vorzugsweise ist der Bandkörper zwischen diesen beiden Antriebs- bzw. Umlenkrollen angeordnet. Bei den in der Unterseite des Bandkörpers vorgesehenen Öffnungen handelt es sich vorzugsweise um Schlitze und insbesondere um sich in Transportrichtung der Wafer erstreckende Längsschlitze. Zweckmäßigerweise ist die Öffnungsweite der in der Unterseite des Bandkörpers vorgesehenen Öffnungen variierbar. Die in dem Endlostransportband vorhandenen Saugöffnungen haben empfohlenermaßen einen kreisförmigen und/oder ellipsenförmigen Querschnitt. Grundsätzlich können diese Saugöffnungen aber auch andere Querschnitte aufweisen. - Es liegt im Rahmen der Erfindung, dass die oben beschriebenen Ansaugkammern in dem Bandkörper angeordnet sind und dass die Ansaugkammern durch quer zur Transportrichtung der Wafer angeordnete Trennwände voneinander getrennt sind.

Eine sehr empfohlene Ausführungsform der Erfindung ist dadurch gekennzeichnet, dass in dem Ablagebereich für die Wafer zumindest eine Blasdüse angeordnet ist, mittels der die Oberfläche eines abzulegenden Wafers mit Blasluft beaufschlagbar ist, so dass der Wafer von dem Endlostransportband auf einen unterhalb des Endlostransportbandes angeordneten Ablageplatz überführbar ist. Zweckmäßigerweise wird ein an dem Endlostransportband angesaugter Wafer von oben mit der Blasluft beaufschlagt, so dass er auf einen unterhalb des Endlostransportbandes angeordneten Ablageplatz fällt. Vorzugsweise sind zumindest zwei Blasdüsen vorhanden bzw. sind einem Ablageplatz zumindest zwei Blasdüsen zugeordnet, die bevorzugt an gegenüberliegenden Seiten des Endlostransportbandes angeordnet sind.

Es liegt im Rahmen der Erfindung, dass ein Ablagebereich für die Wafer eine Mehrzahl von Ablageplätzen aufweist und dass ein Wafer jeweils gezielt von dem Endlostransportband an einem der Ablageplätzen ablegbar ist. Zweckmäßigerweise ist die Mehrzahl von Ablageplätzen in Transportrichtung der Wafer hintereinander angeordnet. Es liegt weiterhin im Rahmen der Erfindung, dass entsprechend der Anzahl der Ablageplätze eine Verlängerung des Endlostransportbandes realisiert wird. Empfohlenermaßen sind den Ablageplätzen Ansaugkammern und/oder Blasdüsen zugeordnet. Bevorzugt ist jedem Ablageplatz des Ablagebereiches eine Ansaugkammer und/oder zumindest eine Blasdüse zugeordnet. Nach einer Ausführungsvariante der Erfindung ist die Vorrichtung mit der Maßgabe eingerichtet, dass die Wafer zunächst an einem ersten Ablageplatz, beispielsweise in einem Wafermagazin abgelegt werden. Wenn dieser Ablageplatz bzw. das Wafermagazin vollständig gefüllt ist, werden die Wafer dann an einem zweiten, zweckmäßigerweise in Transportrichtung hinter dem ersten Ablageplatz angeordneten Ablageplatz bzw. Wafermagazin abgelegt. Dementsprechend könnte ein dritter und vierter usw. Ablageplatz vorgesehen sein.

Dass bei der erfindungsgemäßen Vorrichtung zumindest ein Endlostransportband vorgesehen ist meint, dass in Transportrichtung der Wafer auch zwei oder mehr Endlostransportbänder hintereinander angeordnet sein können und dass die Wafer 1 dann von einem Endlostransportband zum anderen Endlostransportband übergeben werden. So könnte z. B. ein in Transportrichtung hinter einem ersten Endlostransportband angeordnetes zweites Endlostransportband die Wafer zu weiteren Ablageplätzen transportieren. - Bevorzugt ist im Rahmen der Erfindung jedoch ein einziges Endlostransportband, das insbesondere aus zwei parallel zueinander angeordneten endlosen Transportbändern bestehen kann.

Die Erfindung betrifft auch eine Vorrichtung zum Transport und zur Verteilung von Wafem und/oder Solarzellen, wobei eine als Zuführförderer ausgebildete Unterlage vorgesehen ist, mit dem eine Mehrzahl von in Förderrichtung hintereinander angeordneten Wafern förderbar ist und dass eine Mehrzahl von vorzugsweise quer zu dem Zuführförderer angeordneten Endlostransportbändern vorgesehen ist und dass ein Wafer von dem Zuführförderer wahlweise von einem der Endlostransportbänder übernehmbar ist. Die Endlostransportbänder sind dabei entsprechend Patentanspruch 1 ausgebildet und weisen bevorzugt die Merkmale eines oder mehrerer der Patentansprüche 4 bis 12 auf und/oder bevorzugt eines oder mehrere der vorstehend beschriebenen Merkmale auf. Diese Vorrichtung kann insbesondere als Verteilvorrichtung bzw. Sortiervorrichtung für die Wafer eingesetzt werden. Die Wafer können beispielsweise in Abhängigkeit von ihrer Qualität an bestimmte Endlostransportbänder übergeben werden. Wafer gleicher Qualität bzw. vergleichbarer Qualität werden dann vorzugsweise von einem bestimmten Endlostransportband zumindest einem Ablageplatz des Ablagebereiches dieses Endlostransportbandes zugeführt.

Der Erfindung liegt die Erkenntnis zugrunde, dass mit der erfindungsgemäßen Vorrichtung eine überraschend schonende Handhabung bzw. ein überraschend schonender Transport der Wafer möglich ist. Beschädigungen der Wafer aufgrund von mechanischen Beeinträchtigungen können effektiv reduziert bzw. minimiert werden. Nichtsdestoweniger ist die erfindungsgemäße Vorrichtung sehr einfach und wenig aufwendig bzw. wenig komplex aufgebaut. Die erfindungsgemäße Vorrichtung lässt sich insbesondere mit kostengünstigen Komponenten verwirklichen. Im Übrigen ist mit den erfindungsgemäßen Maßnahmen eine sehr funktionssichere und effektive Vereinzelung der Wafer eines Waferstapels möglich.

Nachfolgend wird die Erfindung anhand einer lediglich ein Ausführungsbeispiel darstellenden Zeichnung näher erläutert. Es zeigen in schematischer Darstellung:
- **Fig. 1**: eine Draufsicht auf die erfindungsgemäße Vorrichtung in einer ersten Ausführungsform,
- **Fig. 2**: ausschnittsweise eine Seitenansicht des Gegenstandes nach Fig. 1,
- **Fig. 3**: den Gegenstand gemäß Fig. 2 in einer zweiten Ausführungsform,
- **Fig. 4**: eine Unteransicht auf einen Bandkörper der erfindungsgemäßen Vor- richtung im Teilschnitt,
- **Fig. 5**: eine Draufsicht auf eine weitere Ausführungsform der erfindungs- gemäßen Vorrichtung und
- **Fig. 6**: eine Ansicht des Gegenstandes gemäß Fig. 5.

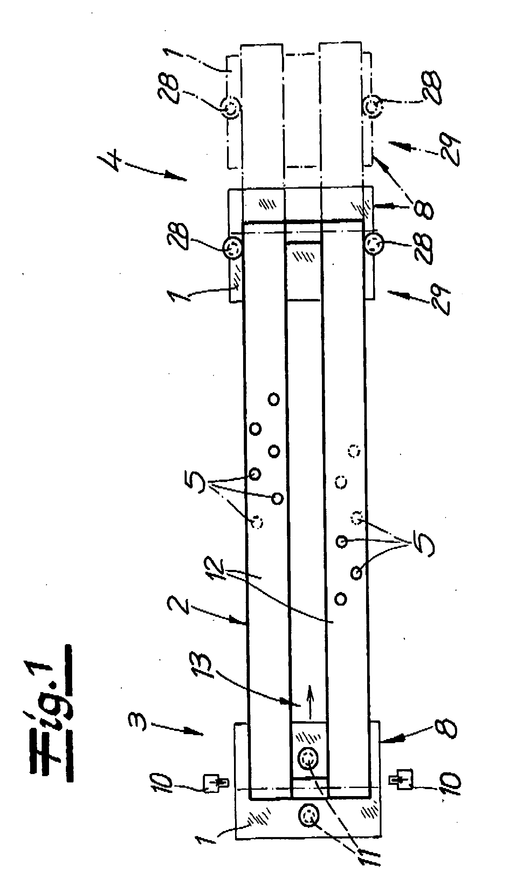

Die Figuren zeigen eine Vorrichtung zum Transport von Wafem 1, wobei die Vorrichtung im Ausführungsbeispiel nach den Fig. 1 bis 4 ein Endlostransportband 2 für den Transport der Wafer 1 aufweist. Die Wafer 1 werden mit dem Endlostransportband 2 von einem Übernahmebereich 3 zu einem Ablagebereich 4 des Endlostransportbandes 2 transportiert. Das Endlostransportband 2 weist eine Vielzahl von Saugöffnungen 5 auf und in weiter unten noch näher erläuterter Weise wird mit einer Ansaugvorrichtung 6 durch Ansaugen von Luft ein Unterdruck an dem Endlostransportband 2 bzw. an den Saugöffnungen 5 angelegt. Mit anderen Worten wird Umgebungsluft durch die Saugöffnungen 5 angesaugt und aufgrund dieser Saugwirkung können die Wafer 1 an der Unterseite 7 des Endlostransportbandes 2 flächig anliegend vorübergehend fixiert werden und von dem Übernahmebereich 3 zu dem Ablagebereich 4 transportiert werden.

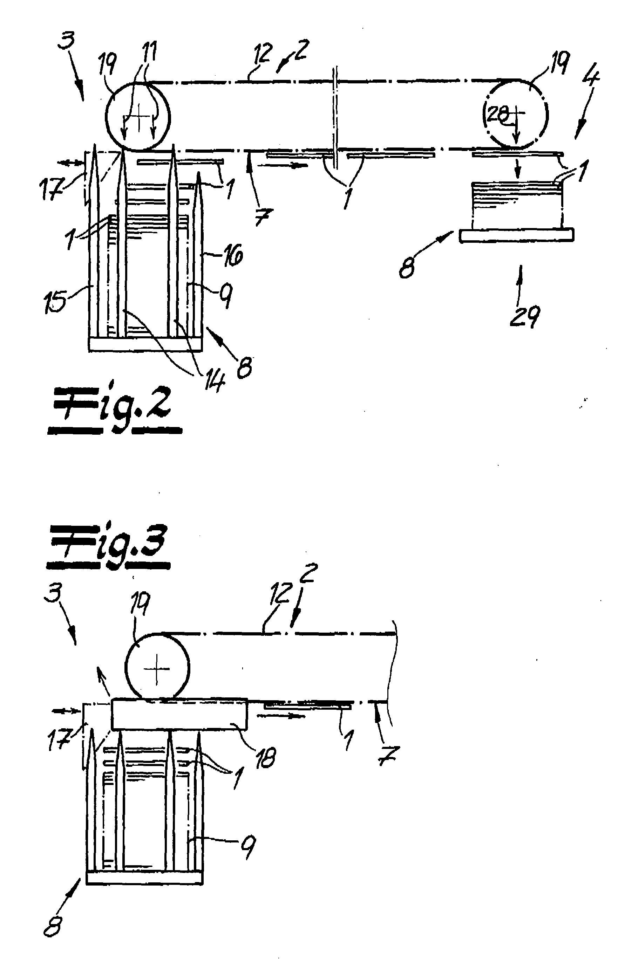

Vorzugsweise und im Ausführungsbeispiel nach den Fig. 1 bis 3 ist im Übernahmebereich 3 ein Wafermagazin 8 unterhalb des Endlostransportbandes 2 angeordnet (siehe insbesondere Fig. 2 und 3). In dem Wafermagazin 8 ist ein Waferstapel 9 aus einer Vielzahl von Wafem 1 aufgenommen. Zum Abtransport eines Wafers 1 zum Ablagebereich 4 muss der im Waferstapel 9 oberste Wafer 1 in Kontakt mit der Unterseite 7 des Endlostransportbandes 2 gebracht werden, damit er aufgrund der beschriebenen Saugwirkung an der Unterseite 7 angesaugt und bis zur Ablage im Ablagebereich 4 vorübergehend fixiert wird. ist. An gegenüberliegenden Seiten des Wafermagazins 8 bzw. des Waferstapels 9 sind seitliche Blasdüsen 10 vorgesehen. Mit diesen seitlichen Blasdüsen 10 wird implusweise Blasluft von der Seite eingeblasen, so dass die oberen Wafer 1 im Waferstapel 9 aufgefächert werden und insbesondere der im Waferstapel 9 oberste Wafer 1 für die Übernahme des Endlostransportbandes 2 bereits teilweise angehoben wird. Um den im Waferstapel 9 obersten Wafer 1 weiter anzuheben bzw. in Kontakt mit der Unterseite 7 des Endlostransportbandes 2 zu bringen, sind bevorzugt und im Ausführungsbeispiel (siehe insbesondere Fig. 1) zwei Bernoulli-Saugelemente 11 vorhanden. Mit diesen Bemoulli-Saugelementen 11 wird ein Unterdruck erzeugt, so dass der im Waferstapel 9 oberste Wafer 1 nach oben gezogen bzw. gesaugt wird und in flächigen Kontakt mit der Unterseite 7 des Endlostransportbandes 2 kommt. Auf diese Weise ist eine funktionssichere Fixierung der Wafer 1 an der Unterseite 7 des Endlostransportbandes 2 möglich.

Im Ausführungsbeispiel nach den Fig. 1 bis 3 wird das Endlostransportband 2 im Übrigen durch zwei parallel zueinander und im Abstand voneinander angeordneten endlosen Transportbändern 12 gebildet, die jeweils eine Vielzahl von Saugöffnungen 5 aufweisen, die wie beschrieben mit Unterdruck beaufschlagt sind. Im Ausführungsbeispiel nach Fig. 1 ist ein Bernoulli-Saugelement 11 im Zwischenraum 13 zwischen den beiden endlosen Transportbändern 12 angeordnet. Das andere Bernoulli-Saugelement 11 ist in der gedachten Verlängerung des Zwischenraumes 13 vor dem vorgenanten Bernoulli-Saugelement 11 und vor dem Endlosiransportband 2 angeordnet.

In Fig. 2 ist im Übernahmebereich 3 des Endlostransportbandes 2 das unterhalb des Endlostransportbandes 2 angeordnete Wafermagazin 8 dargestellt. Dieses Wafermagazin 8 befindet sich für die Übergabe der Wafer 1 an das Endlostransportband 2 in einer in Fig. 2 dargestellten angehobenen Position. Das Wafermagazin 8 weist im Ausführungsbeispiel gemäß Fig. 2 an gegenüberliegenden Seiten jeweils zwei seitliche Führungsstangen 14, sowie an der Rückseite zwei rückseitige Führungsstangen 15 und an der Vorderseite zwei vorderseitige Führungsstangen 16 auf. In der Fig. 2 sind lediglich die beiden vorderen seitlichen Führungsstangen 14 sowie die vordere rückseitige Führungsstange 15 und die vordere vorderseitige Führungsstange 16 erkennbar. Die seitlichen Führungsstangen 14 und die rückseitigen Führungsstangen 15 sind länger ausgebildet als die vorderseitigen Führungsstangen 16 und ragen im Ausführungsbeispiel bis zum Niveau der Unterseite 7 des Endlostransportbandes 2. Dadurch bilden sie seitliche und rückseitige Führungen für die Wafer 1 und verhindern ein seitliches bzw. rückseitiges Verschieben der Wafer 1. Durch die kürzere Ausführung der vorderseitigen Führungsstangen 16 können die Wafer 1 aber problemlos in Transportrichtung von dem Endlostransportband 2 gefördert werden. In den Fig. 2 und 3 ist im Übrigen ein rückseitiger Vorschubkeil 17 strichpunktiert angedeutet worden, der bei Bedarf vorgesehen werden kann und die Wafer 1 gleichsam in Transportrichtung schieben kann. Es liegt im Übrigen im Rahmen der Erfindung, dass bei Übernahme des im Waferstapel 9 obersten Wafers 1 bzw. der im Waferstapel 9 oberen Wafer 1 der Waferstapel 9 in Richtung Endlostransportband 2 nachgeführt bzw. angehoben wird, damit der Abstand des Waferstapels 9 zur Unterseite 7 des Endlostransportbandes 2 konstant bleibt. Dieses Nachführen bzw. Anheben des Waferstapels 9 kann beispielsweise durch einen in den Figuren nicht dargestellten Kurzhubzylinder erfolgen.

Im Ausführungsbeispiel nach Fig. 3 ist die Führung für die Wafer 1 im Übernahmebereich 3 in Form von zwei seitlichen Führungsplatten 18 verwirklicht. In der Fig. 3 ist lediglich die vordere Führungsplatten 18 erkennbar. Mit diesen seitlichen Führungsplatten 18 ist ebenfalls eine effektive seitliche Führung der zu übernehmenden Wafer 1 möglich. Unerwünschte seitliche Verschiebungen der Wafer 1 werden bei der Übernahme vermieden. Zweckmäßigerweise und im Ausführungsbeispiel sind die Führungsplatten 18 für einen Wechsel des Wafermagazins 8 an der Magazineinschubseite hochschwenkbar. Das wird in der Fig. 3 durch einen Pfeil angedeutet. - Da die in den Fig. 2 und 3 dargestellten Führungen für die Wafer 1 Verschiebungen der Wafer 1 vermeiden und somit eine funktionssichere Übernahme der Wafer 1 gewährleisten, kann bei der Übernahme der Wafer 1 das Endlostransportband 2 kontinuierlich weiterlaufen bzw. mit geringer Geschwindigkeit weiterlaufen. Eine unerwünschte Unterbrechung der Bewegung des Endlostransportbandes 2 ist dann nicht erforderlich. Nach der Übernahme eines Wafers 1 wird im Übrigen zweckmäßigerweise auf eine höhere Geschwindigkeit des Endlostransportbandes 2 umgeschaltet um eine entsprechend große Lücke zu dem nächsten zu übernehmenden Wafer 1 zu bilden.

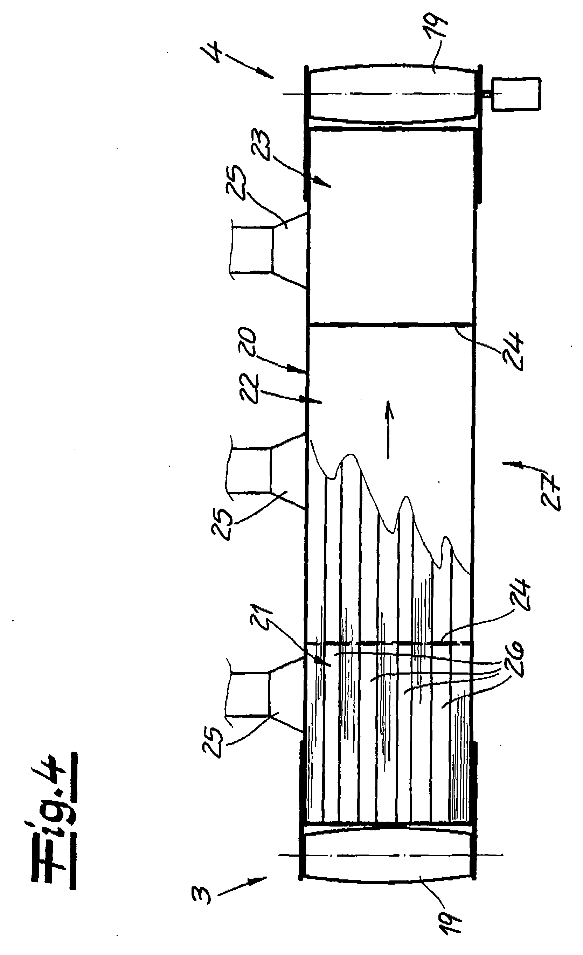

Das Endlostransportband 2 wird über Antriebs- und Umlenkrollen 19 geführt und vorzugsweise von einem zwischen den Antriebs- und Umlenkrollen 19 angeordneten Bandkörper 20 abgestützt. In der Fig. 4 ist ein Bandkörper 20 für ein zu stützendes Endlostransportband 2 dargestellt, das aus lediglich einem endlosen Transportband besteht. Der Bandkörper 20 weist im Ausführungsbeispiel nach Fig. 4 drei in Transportrichtung der Wafer 1 hintereinander angeordnete Ansaugkammern 21, 22, 23 auf, die durch quer zur Transportrichtung angeordnete Trennwände 24 getrennt sind. Jede Ansaugkammer 21, 22, 23 ist durch einen Ansaugstutzen 25 an eine Ansaugvorrichtung 6 angeschlossen. Gemäß einer bevorzugten Ausführungsform der Erfindung kann in den drei Ansaugkammern 21, 22, 23 die Luftansaugung bzw. die Unterdruckerzeugung jeweils separat eingestellt werden. Damit im Übrigen die Saugöffnungen 5 des von dem Bandkörper 20 abgestützten Endlostransportbandes 2 mit Unterdruck beaufschlagt werden können, weist die Unterseite des Bandkörpers 20 Längsschlitze 26 auf, durch die die durch die Saugöffnungen 5 eingesaugte Umgebungsluft in das Innere des Bandkörpers 20 und dann durch die Ansaugstutzen 25 gesaugt werden kann. Vorzugsweise und im Ausführungsbeispiel ist die erste Ansaugkammer 21 dem Übernahmebereich 3 für die Wafer 1 zugeordnet und die zweite Ansaugkammer 22 einem zwischen Übernahmebereich 3 und Ablagebereich 4 angeordneten Transportbereich 27 zugeordnet. Die dritte Ansaugkammer 23 ist dem Ablagebereich 4 für die Wafer 1 zugeordnet. Um ein Lösen der Wafer 1 von der Unterseite 7 des Endlostransportbandes 2 und somit die Ablage der Wafer 1 im Ablagebereich 4 zu bewirken, kann in der dritten Ansaugkammer 23 die Ansaugung bzw. Unterdruckerzeugung gedrosselt werden oder für eine Ablage eines Wafers 1 gegebenenfalls auch vollständig unterbrochen werden.

Zweckmäßigerweise und im Ausführungsbeispiel (siehe insbesondere Fig. 1) sind im Ablagebereich 4 zwei Blasdüsen 28 an gegenüberliegenden Seiten des Endlostransportbandes 2 angeordnet. Mit diesen Blasdüsen 28 können die im Ablagebereich 4 abzulegenden Wafer 1 an ihrer Oberseite mit Blasluft beaufschlagt werden, so dass sie von der Unterseite 7 des Endlostransportbandes 2 in Richtung Ablageplatz 29 gedrückt werden. Bei einem Ablageplatz 29 mag es sich um ein Wafermagazin 8 oder um eine Fördereinrichtung bzw. ein Förderband für die Wafer 1 handeln. Es liegt im Rahmen der Erfindung, dass im Ablagebereich 4 mehrere Ablageplätze 29 hintereinander angeordnet sind. Dann wird zweckmäßigerweise das Endlostransportband 2 entsprechend verlängert. Es liegt fernerhin im Rahmen der Erfindung, dass jedem Ablageplatz 29 eine Ansaugkammer 23 und/oder zumindest eine Blasdüse 28 zugeordnet wird. Die von dem Endlostransportband 2 transportierten Wafer können dann wahlweise an einem bestimmten Ablageplatz 29 abgelegt werden. In der Fig. 1 ist im Übrigen ein zweiter Ablageplatz 29 sowie eine entsprechende Verlängerung des Endlostransportbandes 2 strichpunktiert angedeutet.

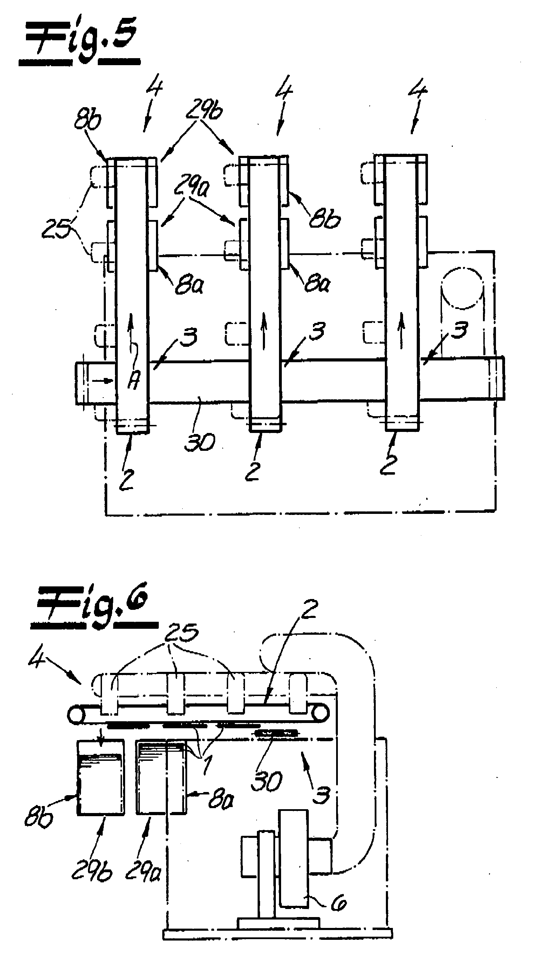

In den Fig. 5 und 6 ist eine besondere Ausführungsform der erfindungsgemäßen Vorrichtung dargestellt. Es handelt sich hierbei um eine Verteilvorrichtung zur Verteilung bzw. Sortierung von Wafem 1 unterschiedlicher Qualität. Die Wafer 1 werden mit einem Zuführförderer 30 zugeführt, auf dem die Wafer 1 zweckmäßigerweise einzeln und mit Abstand hintereinander angeordnet sind. Quer zu dem Zuführförderer 30 sind mit Abstand voneinander drei Endlostransportbänder 2 angeordnet. Jedem Endlostransportband 2 sind im Übernahmebereich 3 zwei Bernoulli-Saugelemente 11 zugeordnet. Mit Hilfe dieser Bernoulli-Saugelemente 11 kann ein auf dem Zuführförderer 30 geförderter Wafer an die Unterseite 7 des jeweiligen Endlostransportbandes 2 angesaugt werden und dann an der Unterseite 7 zum Ablagebereich 4 des jeweiligen Endlostransportbandes 2 transportiert werden. Mit den drei Endlostransportbändern 2 sollen jeweils Wafer 1 einer bestimmten Qualität zu dem jeweiligen Ablagebereich 4 hin transportiert werden. Die Ablagebereiche 4 der Endlostransportbänder 2 weisen im Ausführungsbeispiel jeweils zwei Ablageplätze 29a und 29b auf. Jedem Ablageplatz 29a, 29b sind zwei Blasdüsen 28 zugeordnet, mit denen der abzulegende Wafer 1 an seiner Oberseite mit Blasluft beaufschlagt werden kann. Mit dem in Transportrichtung des Zuführförderers 30 ersten Endlostransportband 2 mögen Wafer 1 einer Qualität A zum Ablagebereich 4 dieses Endlostransportbandes 2 transportiert werden. Die Ablageplätze 29a und 29b sind vorzugsweise und im Ausführungsbeispiel Wafermagazine 8a, 8b. Zunächst wird der erste Ablageplatz 29a bzw. das erste Wafermagazin 8a gefüllt. Wenn dieses Wafermagazin 8a vollständig gefüllt ist, werden die weiteren Wafer 1 der Qualität A zum Ablageplatz 29b bzw. zum Wafermagazin 8b transportiert und dort abgelegt. Grundsätzlich können an dem Endlostransportband 2 auch mehr als zwei Ablageplätze 29a, 29b zugeordnet werden. Die Mehrzahl der Ablagemöglichkeiten bzw. Ablageplätze 29a, 29b ermöglicht es lediglich wenige Endlostransportbänder 2 vorzusehen, die vorzugsweise und im Ausführungsbeispiel in Platz sparender Weise lediglich an einer Seite des Zuführförderers 30 angeordnet sind. Mit der in den Fig. 5 und 6 dargestellten Vorrichtung kann eine besonders funktionssichere und schonende Verteilung bzw. Sortierung der Wafer 1 verschiedener Qualität erfolgen.

## Patentansprüche

1. Vorrichtung zum Transport von Wafem (1) und/oder Solarzellen, wobei zumindest ein Endlostransportband (2) für den Transport der Wafer (1) von einem Übernahmebereich (3) zu einem Ablagebereich (4) des Endlostransportbandes (2) vorhanden ist, wobei das Endlostransportband (2) eine Vielzahl von Saugöffnungen (5) aufweist und wobei zumindest eine Ansaugvorrichtung (6) vorgesehen ist, mit der ein Unterdruck an dem Endlostransportband (2) bzw. an den Saugöffnungen (5) anlegbar ist,
wobei in dem Übernahmebereich (3) des Endlostransportbandes (2) zumindest ein Saugelement angeordnet ist, mit welchem Saugelement ein auf einer unterhalb des Endlostransportbandes (2) angeordneten Unterlage aufliegender Wafer (1) ansaugbar und von der Unterlage abhebbar ist,
und wobei der von dem Saugelement angesaugte Wafer (1) anschließend aufgrund des an den Saugöffnungen (5) des Endlostransportbandes (2) anliegenden Unterdruckes an der Unterseite (7) des Endlostransportbandes (2) ansaugbar und mit dem Endlostransportband (2) abtransportierbar ist.

2. Vorrichtung nach Anspruch 1, wobei die Unterlage ein Wafermagazin (8) ist, in dem ein Waferstapel (9) aus einer Mehrzahl bzw. Vielzahl von Wafem (1) angeordnet ist und wobei mit dem zumindest einen Saugelement der im Waferstapel (9) oberste Wafer (1) ansaugbar und vom Waferstapel (9) abhebbar ist.

3. Vorrichtung nach Anspruch 1, wobei die Unterlage ein Zuführförderer (30) ist, mit dem die Wafer (1) in Förderrichtung hintereinander angeordnet zu dem Endlostransportband (2) bzw. an dem Endlostransportband (2) vorbei förderbar sind.

4. Vorrichtung nach einem der Ansprüche 1 bis 3, wobei zumindest eine Blasdüseinrichtung vorgesehen ist, mit der der zu übernehmende Wafer (1) - insbesondere der im Wafermagazin (8) aufgenommene Waferstapel (9) - seitlich mit Blasluft beaufschlagbar ist, so dass der zu übernehmende Wafer (1) von der Unterlage abhebbar ist, insbesondere so dass der im Waferstapel (9) oberste Wafer von dem Waferstapel (9) abhebbar ist.

5. Vorrichtung nach einem der Ansprüche 1 bis 4, wobei das Saugelement im Übernahmebereich (3) des Endlostransportbandes (2) ein Bemoulli-Saugelement (11) ist,

6. Vorrichtung nach einem der Ansprüche 1 bis 4, wobei das Saugelement im Übernahmebereich (3) des Endlostransportbandes (2) eine Injektordüse ist.

7. Vorrichtung nach einem der Ansprüche 1 bis 6, wobei das Endlostransportband (2) von zwei parallel zueinander angeordneten endlosen Transportbändern (12) gebildet wird, die für den Transport der Wafer (1) vorgesehen sind und wobei jedes der beiden Transportbänder (13) eine Vielzahl von Saugöffnungen (5) aufweist.

8. Vorrichtung nach Anspruch 7, wobei das im Übernahmebereich (3) vorgesehene zumindest eine Saugelement zwischen den das Endlostransportband (2) bildenden beiden endlosen Transportbändern (12) angeordnet ist.

9. Vorrichtung nach einem der Ansprüche 1 bis 8, wobei das Endlostransportband (2) zumindest zwei, vorzugsweise zumindest drei in Transportrichtung der Wafer (1) hintereinander angeordnete Ansaugkammern (21, 22, 23) aufweist, wobei bei zumindest zwei, vorzugsweise bei zumindest drei Ansaugkammern (21, 22, 23) die Luftansaugung bzw. Unterdruckerzeugung jeweils separat einstellbar ist und wobei eine Ansaugkammer (21, 22, 23) dem Ablagebereich (4) für die Wafer (1) zugeordnet ist.

10. Vorrichtung nach einem der Ansprüche 1 bis 9, wobei das zumindest eine Endlostransportband (2) über zumindest einen das Endlostransportband (2) abstützenden Bandkörper (20) geführt wird und wobei in der Unterseite des Bandkörpers (20) Öffnungen für die Saugbeaufschlagung der in dem Endlostransportband (2) vorhandenen Saugöffnungen (5) vorgesehen sind.

11. Vorrichtung nach einem der Ansprüche 9 oder 10, wobei die Ansaugkammern (21, 22, 23) in dem Bandkörper (20) angeordnet sind und wobei die Ansaugkammern (21, 22, 23) durch quer zur Transportrichtung der Wafer (1) angeordnete Trennwände (24) voneinander getrennt sind.

12. Vorrichtung nach einem der Ansprüche 1 bis 11, wobei in dem Ablagebereich (4) für die Wafer (1) zumindest eine Blasdüse (28) angeordnet ist, mittels der die Oberfläche eines abzulegenden Wafers (1) mit Blasluft beaufschlagbar ist, so dass der Wafer (1) von dem Endlostransportband (2) auf einen unterhalb des Endlostransportbandes (2) angeordneten Ablageplatz (29) überführbar ist.

13. Vorrichtung nach einem der Ansprüche 1 bis 12, wobei ein Ablagebereich (4) für die Wafer (1) eine Mehrzahl von Ablageplätzen (29) aufweist und wobei die Wafer (1) jeweils gezielt an einem der Ablageplätze (29) ablegbar sind.

14. Vorrichtung zum Transport und zur Verteilung von Wafem und/oder Solarzellen, wobei eine als Zuführförderer (30) ausgebildete Unterlage vorgesehen ist, mit dem eine Mehrzahl von in Förderrichtung hintereinander angeordneten Wafem (1) förderbar ist, wobei eine Mehrzahl von vorzugsweise quer zu dem Zuführförderer (30) angeordneten Vorrichtungen bzw. Endlostransportbändern (2) nach einem der Ansprüche 1 sowie 4 bis 12 vorgesehen ist und wobei ein Wafer (1) vor dem Zuführförderer (30) wahlweise von einem der Endlostransportbänder (2) übernehmbar ist.

## Geänderte Patentansprüche

### Geänderte Patentansprüche gemäss Regel 137(2) EPÜ.

**1.** Vorrichtung zum Transport von Wafern (1) und/oder Solarzellen, wobei zumindest ein Endlostransportband (2) für den Transport der Wafer (1) von einem Übernahmebereich (3) zu einem Ablagebereich (4) des Endlostransportbandes (2) vorhanden ist, wobei das Endlostransportband (2) eine Vielzahl von Saugöffnungen (5) aufweist und wobei zumindest eine Ansaugvorrichtung (6) vorgesehen ist, mit der ein Unterdruck an dem Endlostransportband (2) bzw. an den Saugöffnungen (5) anlegbar ist,
wobei in dem Übernahmebereich (3) des Endlostransportbandes (2) zumindest ein von den Saugöffnungen (5) des Endlostransportbandes (2) unterschiedliches Saugelement angeordnet ist, mit welchem Saugelement ein auf einer unterhalb des Endlostransportbandes (2) angeordneten Unterlage aufliegender Wafer (1) ansaugbar und von der Unterlage abhebbar ist,
wobei das Saugelement zuschaltbar ist, wenn ein Wafer (1) von dem Endlostransportband (2) übernommen werden soll.
und wobei der von dem Saugelement angesaugte Wafer (1) anschließend aufgrund des an den Saugöffnungen (5) des Endlostransportbandes (2) anliegenden Unterdruckes an der Unterseite (7) des Endlostransportbandes (2) ansaugbar und mit dem Endlostransportband (2) abtransportierbar ist.
